# EUROPÄISCHE PATENTANMELDUNG

(11) **EP 1 168 907 A1**
(43) Veröffentlichungstag der Anmeldung: **02.01.2002**
(21) Anmeldenummer: 00810550.4
(22) Anmeldetag: 22.06.2000
(51) Int. Cl.: H05K 13/04

(54) **Einrichtung zur Montage eines Flip-Chips auf einem Werkstück**

(71) Anmelder: ESEC Trading S.A., 6330 Cham (CH)
(72) Erfinder: Link, Daniel, 6340 Baar (CH)
(74) Vertreter: Falk, Urs, Dr.

(57) **Zusammenfassung**

Eine Einrichtung zur Montage eines Flipchips (1) auf einem Werkstück (2) umfasst eine Entnahmestation (3) zur Bereitstellung des Flipchips (1), eine Transportvorrichtung (4), wenigstens ein an der Transportvorrichtung (4) angeordnetes Greiforgan (5) zur Aufnahme und zum Transport des Flipchips (1) von der Entnahmestation (3) zum Werkstück (2) und eine an der Transportvorrichtung (4) angeordnete Lageerfassungseinrichtung (6) zur Ermittlung der Lage des aufgenommenen Flipchips (1). Die Lageerfassungseinrichtung (6) umfasst einen Schlitten (7), ein Führungselement (8) zur Führung des Schlittens (7), eine Antriebsvorrichtung (9) zum Antrieb des Schlittens (7), eine Messeinrichtung (10) zur Ermittlung der Position des Schlittens (7) und eine am Schlitten (7) befestigte Einzeilenkamera (11).

## Beschreibung

Die Erfindung betrifft eine Einrichtung zur Montage eines Flipchips auf einem Werkstück der im Oberbegriff des Anspruchs 1 genannten Art.

Für die Montage auf einem Werkstück, beispielsweise einem BGA® -Substrat oder einer gedruckten Leiterplatte, werden die Halbleiterchips in der Regel so bereitgestellt, dass ihre aktive Oberfläche nach oben gerichtet ist. Bestimmte Halbleiterchips, insbesondere Mikroprozessoren, müssen jedoch vor der Montage auf dem Werkstück gedreht (geflippt) werden, so dass ihre aktive Oberfläche gegen das Werkstück gerichtet ist. Solche Halbleiterchips werden daher allgemein als Flipchip bezeichnet. Damit die Strukturen des Flipchips mit den Strukturen des Werkstücks übereinstimmen, müssen Lage und Orientierung der Strukturen des Flipchips wie auch der Strukturen des Werkstücks vor der Plazierung des Flipchips auf dem Werkstück bestimmt werden.

Die Anmelderin vertreibt unter dem Produktenamen Micron eine Einrichtung zur Montage von Flipchips, bei der der Flipchip zunächst geflippt, dann von einem Greiforgan aufgenommen und zu einer stationär angeordneten Lageerfassungseinrichtung transportiert, dort vermessen und anschliessend zum Werkstück transportiert und plaziert wird. Als Lageerfassungseinrichtung dient eine herkömmliche CCD-Kamera mit beispielsweise 480 x 640 Pixeln. Die stationäre Anordnung der Lageerfassungseinrichtung hat einen Zeitverlust zur Folge, da jeder Flipchip zuerst zur Lageerfassungseinrichtung transportiert werden muss und erst danach zum Werkstück transportiert werden kann.

Um diesen Zeitverlust zu vermeiden, wurde in der Patentschrift US 5768759 vorgeschlagen, in der Nähe des Werkstücks einen stationären Spiegel und neben dem Greiforgan eine Kamera anzuordnen, so dass sich die aktive Oberfläche des aufgenommenen Flipchips beim Überfahren des Spiegels im Blickfeld der Kamera befindet. Technologische Schwierigkeiten haben die praxistaugliche Umsetzung dieser Lösung bisher verhindert.

Der Erfindung liegt die Aufgabe zugrunde, die Erfassung der Lage und Orientierung der Flipchips bei deren Montage zu beschleunigen und damit den Durchsatz des Montageautomaten zu erhöhen.

Die genannte Aufgabe wird erfindungsgemäss gelöst durch die Merkmale des Anspruchs 1. Vorteilhafte Ausgestaltungen ergeben sich aus den abhängigen Ansprüchen.

Eine Einrichtung zur Montage eines Flipchips auf einem Werkstück umfasst mindestens eine Entnahmestation. wo die Flipchips bereitgestellt werden, eine in horizontalen Richtungen x und y bewegliche Transportvorrichtung mit einem Greiforgan zur Aufnahme und zum Transport des Flipchips von der Entnahmestation zum Werkstück, und eine an der Transportvorrichtung angeordnete Lageerfassungseinrichtung zur Ermittlung der Lage und Orientierung des aufgenommenen Flipchips. Erfindungsgemäss ist als Lageerfassungseinrichtung eine Einzeilenkamera vorgesehen, die während des Transport des Flipchips von der Entnahmestation zum Werkstück unter dem Flipchip hindurchbewegt wird und dabei ein Bild der Oberfläche des Flipchips scannt und an ein Bildverarbeitungsmodul überträgt. Zu diesem Zweck sind an der Transportvorrichtung ein lineares Führungselement zur Führung eines in einer vorbestimmten Richtung bewegbaren Schlittens, eine Antriebsvorrichtung zum Antrieb des Schlittens und eine Messeinrichtung zur Ermittlung der Position des Schlittens vorgesehen. Die Einzeilenkamera ist am Schlitten befestigt und ihr Blickfeld ist nach oben gegen die aktive Oberfläche des Flipchips gerichtet.

Nachfolgend werden Ausführungsbeispiele der Erfindung anhand der Zeichnung näher erläutert.

Es zeigen:
- Fig. 1: eine Einrichtung zur Montage eines Flipchips auf einem Werkstück,
- Fig. 2: Teile dieser Einrichtung,
- Fig. 3: einen Scanbereich,
- Fig. 4: eine weitere Einrichtung zur Montage eines Flipchips, und
- Fig. 5: eine Vorrichtung zur Beleuchtung des Flipchips.

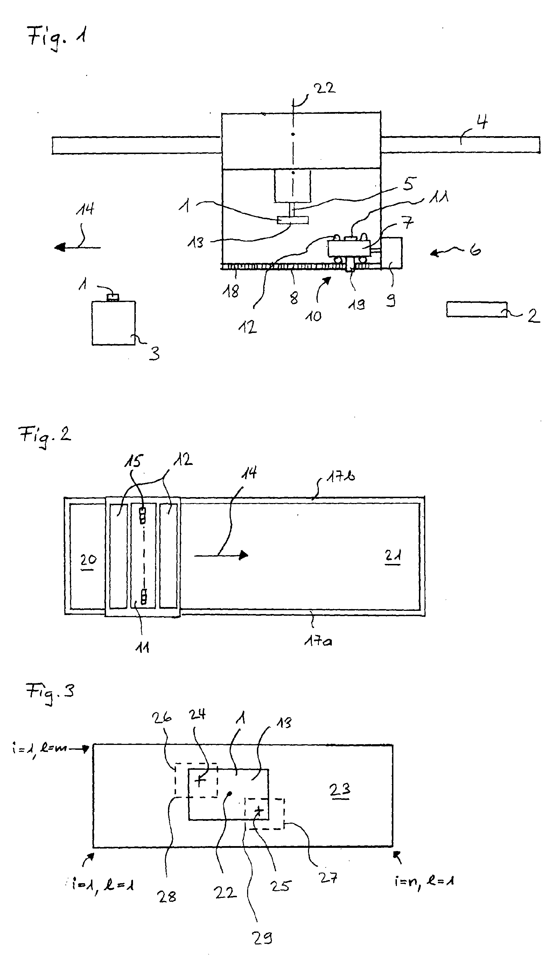

Die Fig. 1 zeigt in schematischer Darstellung eine Einrichtung zur Montage eines Flipchips 1 auf einem Werkstück 2. Die Einrichtung umfasst mindestens eine Entnahmestation 3, wo die Flipchips 1 bereitgestellt werden, eine Transportvorrichtung 4 mit einem Greiforgan 5 zur Aufnahme und zum Transport des Flipchips 1 von der Entnahmestation 3 zum Werkstück 2, und eine an der Transportvorrichtung 4 angeordnete Lageerfassungseinrichtung 6 zur Ermittlung der Lage und Orientierung des aufgenommenen Flipchips 1. Die Lageerfassungseinrichtung 6 umfasst einen bewegbaren Schlitten 7, ein an der Transportvorrichtung 4 befestigtes lineares Führungselement 8 zur Führung des Schlittens 7, eine Antriebsvorrichtung 9 zum Antrieb des Schlittens 7 und eine Messeinrichtung 10 zur Erfassung der Position des Schlittens 7. Der Schlitten 7 weist eine Einzeilenkamera 11 und Beleuchtungsmittel 12 auf.

Die Zufuhr und Bereitstellung der Flipchips 1 kann auf verschiedene Arten erfolgen. Eine erste Möglichkeit besteht darin, die Flipchips 1 ungeflippt wie normale Halbleiterchips, d.h. mit nach oben gerichteter aktiver Oberfläche 13, auf einem auf einen Rahmen aufgespannten Tape bereitzustellen und mittels eines Wafertisches einem Flipper zuzuführen. Der Flipper ergreift einen Halbleiterchip nach dem andern, flippt ihn und stellt ihn zur Aufnahme durch das Greiforgan 5 bereit. In diesem Fall dient der Flipper als Entnahmestation 3. Eine zweite Möglichkeit besteht darin, die Halbleiterchips vorgängig auf einer anderen Maschine zu flippen und in Taschen eines Trägerbandes abzufüllen, das auf eine Spule aufgewickelt wird. In diesem Fall dient als Entnahmestation eine Zuführeinheit, wie sie beispielsweise aus der europäischen Patentanmeldung EP 859544 bekannt ist. Die Flipchips 1 können aber auch auf andere Arten zugeführt werden.

Das Greiforgan 5 erfasst somit den Flipchip 1 an der Entnahmestation 3 auf seiner Rückseite, so dass seine aktive Oberfläche 13 nach unten zeigt. Das Blickfeld der Einzeilenkamera 11 ist nach oben gegen das Greiforgan 5 und damit auf die aktive Oberfläche 13 des aufgenommenen Flipchips 1 gerichtet.

Das Führungselement 8 erlaubt die Bewegung des Schlittens 7 in einer vorbestimmten Bewegungsrichtung 14, die parallel zu einer Transportrichtung der Transportvorrichtung 4 ausgerichtet ist. Die Fig. 2 zeigt in der Aufsicht die Ausrichtung der Einzeilenkamera 11 in Bezug auf die Bewegungsrichtung 14 des Schlittens 7. Die Einzeilenkamera 11 besteht aus lichtempfindlichen Photosensoren 15 (von denen nur wenige dargestellt sind), die nebeneinander entlang einer Linie 16 (oder Zeile) angeordnet sind. Die Zahl der Photosensoren 15 beträgt z.B. m=1024, wobei jedem Photosensor 15 ein Indexwert zwischen k = 1 und k = m zugeordnet ist. Die Abmessung eines einzelnen Photosensors beträgt z.B. 28µm x 28µm. Die Linie 16 verläuft orthogonal zur Bewegungsrichtung 14. Die Beleuchtungsmittel 12 dienen dazu, den Flipchip 1 beim Scannen gleichförmig zu beleuchten.

Das Führungselement 8 besteht im wesentlichen aus einem rechteckförmigen Rahmen mit zwei parallel zur Bewegungsrichtung 14 verlaufenden Führungsschienen 17a und 17b. Alternativ könnte eine einzige Führungsschiene vorgesehen sein, an der der Schlitten 7 hin und her gleitet. (In der Fig. 2 würden dann die Führungsschiene 17b und die beiden Schmalseiten des Rahmens entfallen). Die Antriebsvorrichtung 9 besteht z.B. aus einem am Rahmen befestigten Motor, der den Schlitten 7 über einen Zahnriemen antreibt. Die Messeinrichtung 10 (Fig. 1) zur Ermittlung der Position des Schlittens 7 besteht aus einem an der Führungsschiene 17a angebrachten Linearencoder, beispielsweise einem Metall- oder Glasmassstab 18 (Fig. 1) und einem am Schlitten 7 befestigten Messkopf 19 (Fig. 1) zum Ablesen des Metall- bzw. Glasmassstabes 18. Mittels der Antriebsvorrichtung 9 kann der Schlitten 7 von einer ersten Endposition 20, die sich auf der einen Seite des Greiforgans 5 befindet, zu einer zweiten Endposition 21, die sich in Bewegungsrichtung 14 gesehen auf der entgegengesetzten Seite des Greiforgans 5 befindet, verschoben werden. Das Ausgangssignal der Einzeilenkamera 11 wird an ein Bildverarbeitungsmodul übertragen, das aus den zeilenweise übertragenen Bildzeilen ein zweidimensionales Bild bildet und anschliessend aus diesem Bild in bekannter Weise die Lage und Orientierung des gegriffenen Flipchips 1 bestimmt.

Ein besonderer Stellenwert kommt der Synchronisation der Bewegung des Schlittens 7 mit der Einzeilenkamera 11 zu. Die Synchronisation erfolgt vorzugsweise mittels der Messeinrichtung 10 auf folgende Art: Während der Bewegung des Schlittens 7 von seiner ersten Endposition 20 zu seiner zweiten Endposition 21 wird dessen aktuelle Position mittels der Messeinrichtung 10 laufend erfasst. Immer dann, wenn der Schlitten 7 eine vorbestimmte Position pᵢ erreicht, wobei der Index i eine ganze Zahl bezeichnet und beispielsweise von i = 1 bis zu i = n läuft, wird die Einzeilenkamera 11 getriggert zur Aufnahme einer neuen Bildzeile bᵢ. Anschliessend wird die Bildzeile bᵢ an das Bildverarbeitungsmodul übertragen. Dem Scanbereich der Einzeilenkamera 11 kann somit eine Pixelmatrix von m * n Pixeln zugeordnet werden, wobei jeder Pixel durch die zwei Indices i und k definiert ist.

Um ein lückenloses Bild zu erhalten, muss der Abstand A zwischen aufeinanderfolgenden Positionen p, und pᵢ₊₁ der Grösse der Photosensoren 15 entsprechen. Die Pixelkoordinaten (x₁, yₖ) des Zentrums des Pixels mit den Pixelindices (i, k) ergeben sich dann zu x₁ = (i-½) * A und yₖ= (k-½) * A. Im vorliegenden Beispiel hat der Abstand A den Wert A = 28µm.

Um den gegriffenen Flipchip 1 in korrekter Lage auf dem Werkstück 2 plazieren zu können, müssen zunächst die Lage und die Orientierung bzw. eine allfällige Verschiebung und/oderVerdrehung des gegriffenen Flipchips 1 bezüglich des Greiforgans 5 bzw. der durch die Spitze des Greiforgans 5 verlaufenden Symmetrieachse 22 bestimmt werden und es muss die Position der Symmetrieachse 22 in einem globalen Maschinenkoordinatensystem bekannt sein. Die Eichung der Position der Symmetrieachse 22 bezüglich des globalen Maschinenkoordinatensystems erfolgt auf an sich bekannte Weise und wird hier nicht erläutert. Die Beziehung zwischen den Pixelkoordinaten (xᵢ, yₖ) der Lageerfassungseinrichtung 6 und der Symmetrieachse 22 des Greiforgans 5 wird bestimmt, indem der Schlitten 7 unter dem Greiforgan 5 hindurchbewegt wird, wobei für vorbestimmte Werte des Indexes i bei der zugehörigen Position pᵢ eine Bildzeile bᵢ aufgenommen, die Bildzeilen bᵢ zum Bild des Greiforgans 5 zusammengesetzt und durch Auswertung des Bildes die Koordinaten (x_{g}, y_{g}) der Spitze des Greiforgans 5 bzw. der durch die Spitze des Greiforgans 5 verlaufenden Symmetrieachse 22 bestimmt wird. Danach können die Pixelkoordinaten (xᵢ, yₖ) jedes Pixels (i, k) in Koordinaten des globalen Maschinenkoordinatensystems umgerechnet werden.

Im Normalbetrieb arbeitet die Einrichtung gemäss folgenden Schritten:
1. Die Transportvorrichtung 4 bewegt das Greiforgan 5, bis es sich über dem nächsten zu plazierenden Flipchip 1 befindet. Das Greiforgan 5 wird abgesenkt, der Flipchip 1 aufgenommen und das Greiforgan 5 wieder angehoben.
2. Die Transportvorrichtung 4 bewegt das Greiforgan 5 zur Zielposition über dem Werkstück 2, in der der Flipchip 1 bei idealer Aufnahme durch das Greiforgan 5, d.h. bei Übereinstimmung von Ist-Position und Soll-Position des Flipchips 1, korrekt auf dem Werkstück 2 plaziert wird. Während dieser Bewegung der Transportvorrichtung 4 wird der Schlitten 7 von der ersten Endposition 20 zur zweiten Endposition 21 bewegt und dabei ein Bild des gegriffenen Flipchips 1 aufgenommen. Sobald das aus den Bildzeilen zusammengesetzte Bild vollständig erfasst ist, werden daraus die Lage und die Orientierung des Flipchips 1 bezüglich des Greiforgans 5 bestimmt. Eine allfällige Verdrehung des Flipchips 1 bezüglich seiner Sollposition wird durch Drehen des Greiforgans 5 um seine vertikal verlaufende Symmetrieachse 22 (Fig. 1) korrigiert, während eine allfällige Verschiebung gegenüber seiner Sollposition durch Anfahren einer neuen Zielposition über dem Werkstück 2 korrigiert wird.
3. Plazieren des Flipchips 1 auf dem Werkstück 2.

Während der Rückfahrt der Transportvorrichtung 4 kann die Lage des Greiforgans 5 nachgeeicht, d.h. die Koordinaten (x_{g}, y_{g}) der Symmetrieachse 22 neu bestimmt werden, so dass eine allfällige Temperaturdrift der Lage des Greiforgans 5 laufend auskorrigigert wird.

Anhand der Fig. 3 werden nun gewisse Optimierungsmöglichkeiten erläutert. Die Fig. 3 zeigt den Scanbereich 23 der Einzeilenkamera 11, die Symmetrieachse 22 des Greiforgans 5, den vom Greiforgan 5 gegriffenen Flipchip 1 mit zwei diagonal versetzten Strukturen 24 und 25 für die Bestimmung seiner Lage und Orientierung, sogenannten Fiducials, und zwei virtuelle Fenster 26 und 27. Der Scanbereich 23 besteht aus den n Bildzeilen ä m Pixeln. Um die Information über Lage und Orientierung des Flipchips 1 zu erhalten, ist es nicht nötig, den gesamten Scanbereich 23 abzufahren, sondern es genügt, wenn die Einzeilenkamera 11 den Bereich der beiden Fenster 26 und 27 scannt bzw. nur Daten liefert, die zu den Fenstern 26 und 27 gehören. Die beiden Fenster 26 und 27 weisen vorzugsweise eine vorbestimmte Grösse von h * q Pixeln, beispielsweise von h=480 * q=640 Pixeln auf. Die Lage jedes der beiden Fenster 26 und 27 wird entsprechend der Lage der Strukturen 24 und 25 festgelegt und durch Angabe der Pixelkoordinaten eines Referenzpunktes 28 bzw. 29, beispielsweise des linken unteren Eckpunktes, vollständig definiert. Im Beispiel der Fig. 3 hat der Referenzpunkt 28 des Fensters 26 die Pixelkoordinaten i=435, k=1320, der Referenzpunkt 29 des Fensters 27 die Pixelkoordinaten i=1212, k=100 und die Symmetrieachse 22 des Greiforgans 5 die Pixelkoordinaten i=800, k=1006.

Im Betrieb wird die Einzeilenkamera 11 so gesteuert, dass sie zunächst den Bereich der Positionen p₄₃₅ bis p₁₀₇₄ scannt und dabei jeweils die Helligkeitswerte der Pixel k=1320 bis k=1899 an das Bildverarbeitungsmodul überträgt zur Bildung eines Bildes des ersten Fensters 26, und dass sie danach den Bereich der Positionen p₁₂₁₂ bis p₁₈₅₁ scannt und dabei jeweils die Helligkeitswerte der Pixel k=100 bis k=579 an das Bildverarbeitungsmodul überträgt zur Bildung eines Bildes des zweiten Fensters 27. Im Bildverarbeitungsmodul werden aus den beiden Bildern die Lage der Strukturen 24 und 25 und daraus Lage und Orientierung des Flipchips 1 bestimmt.

Beim vorliegenden Beispiel betragen die Abmessungen der Photosensoren 15 und damit die Grösse der Pixel 28µm x 28µm. Bei einer Scangeschwindigkeit des Schlittens 7 von 0.5 m/s stehen somit für die Auslesung einer Bildzeile 56µs zur Verfügung. Diese Zeit reicht aus, um die 1024 Pixel einer Bildzeile an das Bildverarbeitungsmodul zu übertragen. Die Pixelgrösse des gescannten Bildes beträgt dann 28µm * 28µm. Es ist auch möglich, bei gleichbleibender Auslesezeit von 56µs die Scangeschwindigkeit des Schlittens 7 auf 1 m/s zu verdoppeln, dabei aber nur für jeden zweiten Wert des Indexes i eine Bildzeile b; aufzunehmen und auszulesen. In diesem Fall beträgt die Pixelgrösse 56µm * 28µm. Mittels Interpolation werden dann Zwischenwerte so berechnet, dass jeder gemessenen Bildzeile eine benachbarte interpolierte Bildzeile zugeordnet werden und dann die Auswertung des Bildes im Bildverarbeitungsmodul in analoger Weise erfolgen kann.

Um die Scanzeit so kurz wie möglich zu halten, wird der Schlitten 7 in vorbestimmten Fahrbereichen, nämlich den ausserhalb der beiden Fenster 26, 27 liegenden Fahrbereichen, mit der grösstmöglichen Geschwindigkeit bewegt, d.h. er erfährt zunächst eine starke Beschleunigung und dann eine starke Abbremsung, während der Schlitten 7 in den den beiden Fenstern 26, 27 entsprechenden Fahrbereichen mit konstanter, vorgegebener Geschwindigkeit bewegt wird.

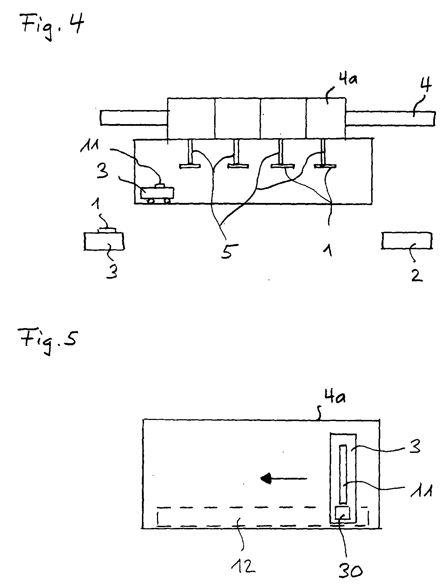

Es ist möglich und vorteilhaft, wie in der Fig. 4 gezeigt ist, anstelle eines einzigen Greiforgans 5 mehrere, nebeneinander angeordnete Greiforgane 5 an der Transportvorrichtung 4 vorzusehen, beispielsweise zwei oder vier, so dass im Betrieb jeweils mehrere Flipchips 1 von der Entnahmestation 3 entnommen, während des Transportes zum Werkstück 2 hin mittels der Einzeilenkamera 11 vermessen und anschliessend in korrekter Lage auf dem Werkstück 2 plaziert werden können.

Weiter können die Beleuchtungsmittel 12 am beweglichen Kopf 4a der Transportvorrichtung 4 (Fig. 4) angeordnet sein. Die Beleuchtungsmittel 12 haben vorzugsweise eine längliche Form und sind in Bewegungsrichtung 14 des Schlittens 7 ausgerichtet. Auf dem Schlitten 7 ist ein Spiegel 30 montiert, der das von den Beleuchtungsmitteln 12 ausgestrahlte Licht beim Scannen auf den gegriffenen Flipchip 1 reflektiert. Die Fig. 5 zeigt schematisch den Schlitten 7 mit der Einzeilenkamera 11 und dem Spiegel 30, sowie, mit gestrichelter Linie, die an der Transportvorrichtung 4 angeordneten Beleuchtungsmittel 12. Im Strahlengang zwischen den Beleuchtungsmitteln 12 und dem Flipchip 1 kann zusätzlich ein Diffusor angeordnet werden.

## Patentansprüche

1. Einrichtung zur Montage eines Flipchips (1) auf einem Werkstück (2), mit einer Entnahmestation (3) zur Bereitstellung des Flipchips (1), mit einer Transportvorrichtung (4) und wenigstens einem an der Transportvorrichtung (4) angeordneten Greiforgan (5) zur Aufnahme und zum Transport des Flipchips (1) von der Entnahmestation (3) zum Werkstück (2), und mit einer an der Transportvorrichtung (4) angeordneten Lageerfassungseinrichtung (6) zur Ermittlung der Lage des aufgenommenen Flipchips (1), **dadurch gekennzeichnet, dass** die Lageerfassungseinrichtung (6) einen Schlitten (7), ein lineares Führungselement (8) zur Führung des Schlittens (7), eine Antriebsvorrichtung (9) zum Antrieb des Schlittens (7), eine Messeinrichtung (10) zur Ermittlung der Position des Schlittens (7) und eine am Schlitten (7) befestigte Einzeilenkamera (11) umfasst.

2. Einrichtung nach Anspruch 1, **dadurch gekennzeichnet, dass** die Synchronisation der Bewegung des Schlittens (7) mit der Aufnahme von Bildzeilen der Einzeilenkamera (11) mittels der Messeinrichtung (10) erfolgt.

3. Einrichtung nach Anspruch 1 oder 2, **dadurch gekennzeichnet, dass** die Antriebsvorrichtung (9) den Schlitten (7) in ersten vorbestimmten Bereichen mit variabler Geschwindigkeit und in zweiten vorbestimmten Bereichen mit konstanter Geschwindigkeit antreibt.

4. Einrichtung nach einem der Ansprüche 1 bis 3, **dadurch gekennzeichnet, dass** für die Beleuchtung des Flipchips (1) an der Transportvorrichtung (4) Beleuchtungsmittel (12) angeordnet sind und dass auf dem Schlitten (7) ein Spiegel (30) zur Umlenkung des von den Beleuchtungsmitteln (12) ausgestrahlten Lichts angeordnet ist.
